(19) Europäisches Patentamt

European Patent Office

Office européen des brevets

(11) EP 0 849 881 A2

## (12) EUROPÄISCHE PATENTANMELDUNG

(43) Veröffentlichungstag:
24.06.1998 Patentblatt 1998/26

(51) Int. Cl.$^6$: H03K 5/08

(21) Anmeldenummer: 97122318.5

(22) Anmeldetag: 17.12.1997

(84) Benannte Vertragsstaaten:
AT BE CH DE DK ES FI FR GB GR IE IT LI LU MC
NL PT SE
Benannte Erstreckungsstaaten:
AL LT LV MK RO SI

(30) Priorität: 19.12.1996 DE 19653192

(71) Anmelder:
SGS-THOMSON MICROELECTRONICS GMBH
85630 Grasbrunn (DE)

(72) Erfinder:
• Roither, Gerhard
81827 München (DE)
• Hackl, Günther
84503 Altötting (DE)
• Fischer, Uwe
82008 Unterhaching (DE)

(74) Vertreter: Hirsch, Peter
Klunker Schmitt-Nilson Hirsch
Winzererstrasse 106
80797 München (DE)

### (54) Monolithisch integrierte Signalverarbeitungsschaltung

(57) Monolithisch integrierte Signalverarbeitungsschaltung mit einem zwischen einen Signaleingangsanschluß (SE) und einen Signalausgangsanschluß (SA) geschalteten Signallängszweig; mit einem Bezugspotentialanschluß (GND); mit einem seriell in den Signallängszweig eingefügten Längskondensator ($C_{offs}$), der eine parasitäre Kapazität ($C_{par}$) aufweist, die wie ein Kondensator wirkt, der zwischen eine zum Signaleingangsanschluß (SE) weisende erste Elektrode des Längskondensators ($C_{offs}$) und den Bezugspotentialanschluß (GND) geschaltet ist; und mit einem ersten Querkondensator (C2), der zwischen die erste Elektrode des Längskondensators ($C_{offs}$) und den Bezugspotentialanschluß (GND) geschaltet ist; wobei der erste Querkondensator (C2) mindestens teilweise durch die parasitäre Kapazität ($C_{par}$) gebildet ist.

FIG.1

EP 0 849 881 A2

## Beschreibung

Die Erfindung betrifft eine monolithisch integrierte Signalverarbeitungsschaltung.

Beispiele für die Verwendung einer derartigen Signalverarbeitungsschaltung sind ein Tiefpaßfilter oder eine Analogsignal-Rechtecksignal-Umformvorrichtung mit Offsetkompensation.

Zur Realisierung eines Kondensators in einer monolithisch integrierten Signalverarbeitungsschaltung ist eine bestimmte Chipfläche erforderlich, deren Größe vom Kapazitätswert des zu realisierenden Kondensators abhängt. Je größer der gewünschte Kapazitätswert ist, umso größer ist die erforderliche Chipfläche

Monolithisch integrierte Halbleiterschaltungen haben heutzutage einen sehr hohen Integrationsgrad pro Chip erreicht. Da die auf einem Chip unterzubringenden Schaltungen immer komplexer und umfangreicher werden, bemüht man sich an allen Stellen einer integrierten Halbleiterschaltung um eine Reduzierung der erforderlichen Chipfläche.

Bei einer herkömmlichen Analogsignal-Rechtecksignal-Umformschaltung mit Offsetkompensation, bei welcher die parasitäre Kapazität des Längskondensators nicht in der erfindungsgemäßen Weise genutzt wird, ist die zum Signaleingangsanschluß weisende Seite des Längskondensators über einen Umschalter entweder mit dem Signaleingangsanschluß oder mit dem Querkondensator verbunden. Zu dem Querkondensator, der einen ersten Querkondensator darstellt, ist ein zweiter Querkondensator parallel geschaltet, der über einen zweiten Umschalter entweder mit dem Signaleingangsanschluß oder dem ersten Querkondensator verbunden ist.

In Halbleiterschaltungen monolithisch integrierte Schalter werden durch elektronische Schaltbauelemente gebildet, meist in Form von Schalttransistoren, bei denen es sich um MOS-Transistoren handeln kann. Während ein EIN-/AUS-Schalter mit einem derartigen Schalttransistor gebildet werden kann, sind für einen Umschalter zwei derartige Schalttransistoren erforderlich. Umschalter benötigen daher mindestens die doppelte Chipfläche wie EIN-/AUS-Schalter.

Der vorliegenden Erfindung liegt die Aufgabe zugrunde, bei einer monolithisch integrierten Signalverarbeitungsschaltung die erforderliche Chipfläche zu reduzieren und insbesondere die bekannte, als Analogsignal-Rechtecksignal-Umformschaltung ausgelegte Signalverarbeitungsschaltung derart weiterzubilden, daß die parasitäre Kapazität des Längskondensators für die Querkapazität nutzbar ist.

Dies gelingt mit einer Signalverarbeitungsschaltung, wie sie im Anspruch 1 angegeben ist. Vorteilhafte Weiterbildungen dieser Signalverarbeitungsschaltung sind in den Ansprüchen 2 bis 5 angegeben. Bei der Herstellungstechnik, die für die monolithische Integration von Kondensatoren üblich ist, ergeben sich Kondensatoren, die neben der beabsichtigten Kapazität noch eine parasitäre Kapazität besitzen. Diese Erscheinung, die sich allgemein störend bemerkbar macht, wird gemäß der vorliegenden Erfindung zur Reduzierung der Chipfläche ausgenutzt.

Bei einem Längskondensator, wie ihn die erfindungsgemäße Signalverarbeitungsschaltung aufweist, ergibt sich eine parasitäre Kapazität, die wie ein Kondensator wirkt, der zwischen eine Elektrode des Längskondensators und den Bezugspotentialanschluß, der im allgemeinen einen Masseanschluß darstellt, geschaltet ist. Erfindungsgemäß wird nun der Querkondensator derart in der Signalverarbeitungsschaltung untergebracht, daß er parallel zur parasitären Kapazität des Längskondensators liegt. Dadurch läßt sich die parasitäre Kapazität des Längskondensators für den Querkondensator einspannen, derart, daß die erforderliche Querkapazität mindestens zu einem Teil durch die parasitäre Kapazität des Längskondensators gebildet wird. Das heißt, die Kapazität des eigentlichen Querkondensators kann um den Betrag der parasitären Kapazität verringert werden. Bei Anwendungsfällen, in denen die für den Querkondensator erforderliche Kapazität im Größenbereich der parasitären Kapazität liegt, kam der Querkondensator ganz durch die parasitäre Kapazität gebildet werden.

Bei der erfindungsgemäßen Schaltung kann daher die Kapazität des Querkondensators verringert oder der Querkondensator ganz weggelassen werden, was zu einer entsprechenden Reduzierung der erforderlichen Chipfläche gegenüber Schaltungen führt, bei denen man die parasitäre Kapazität des Längskondensators nicht nutzt.

Gemäß Anspruch 3 ist der erste Querkondensator der parasitären Kapazität des Längskondensators unmittelbar parallel geschaltet derart, daß die zum Signaleingangsanschluß weisende Elektrode des Längskondensators und die zum Signallängszweig weisende Elektrode des ersten Querkondensators in einem Schaltungspunkt miteinander verbunden sind. Zwischen diesen Schaltungspunkt und die zum Signallängszweig weisende Elektrode des zweiten Querkondensators ist ein EIN-/AUS-Schalter geschaltet, der im leitenden Zustand die beiden Querkondensatoren parallel schaltet. Zwischen den Schaltungspunkt und den Signaleingangsanschluß ist ein weiterer EIN-/AUS-Schalter geschaltet, der im leitenden Zustand den Signaleingangsanschluß mit dem Längskondensator verbindet.

Da beide Umschalter der bereits existierenden Schaltung bei der erfindungsgemäßen Schaltung je durch einen EIN-/AUS-Schalter ersetzt worden sind, und zwar in einer Schaltungskonfiguration, welche es erlaubt, die parasitäre Kapazität des Längskondensators für den ersten Querkondensator zu nutzen, ist mit der erfindungsgemäßen Schaltung eine beachtliche Einsparung an Chipfläche gegenüber der bereits existierenden Schaltung erreichbar.

Die Erfindung wird nun anhand von Ausführungsformen näher erläutert. In den Zeichnungen zeigen:

**Fig. 1** eine erfindungsgemäße Signalverarbeitungsschaltung in Form einer Analogsignal-Rechtecksignal-Umformschaltung;

**Fig. 2** eine Analogsignal-Rechtecksignal-Umformschaltung der bekannten, bereits existierenden Art;

**Fig. 3** eine beispielsweise Signalform des der Analogsignal-Rechtecksignal-Umformschaltung der Figur 1 zugeführten Analogsignals;

**Fig. 4** ein Schaltersteuersignal;

**Fig. 5** die Form des Analogsignals an einem geschalteten Schaltungspunkt der in Fig. 1 gezeigten Schaltung; und

**Fig. 6** den Verlauf der Spannung über dem geschalteten Querkondensator der in Fig. 1 gezeigten Schaltung.

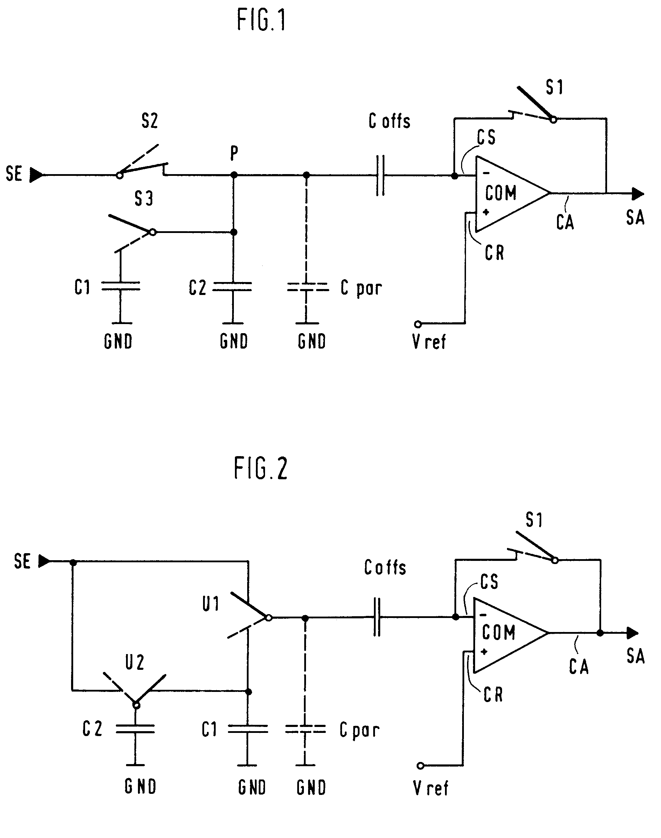

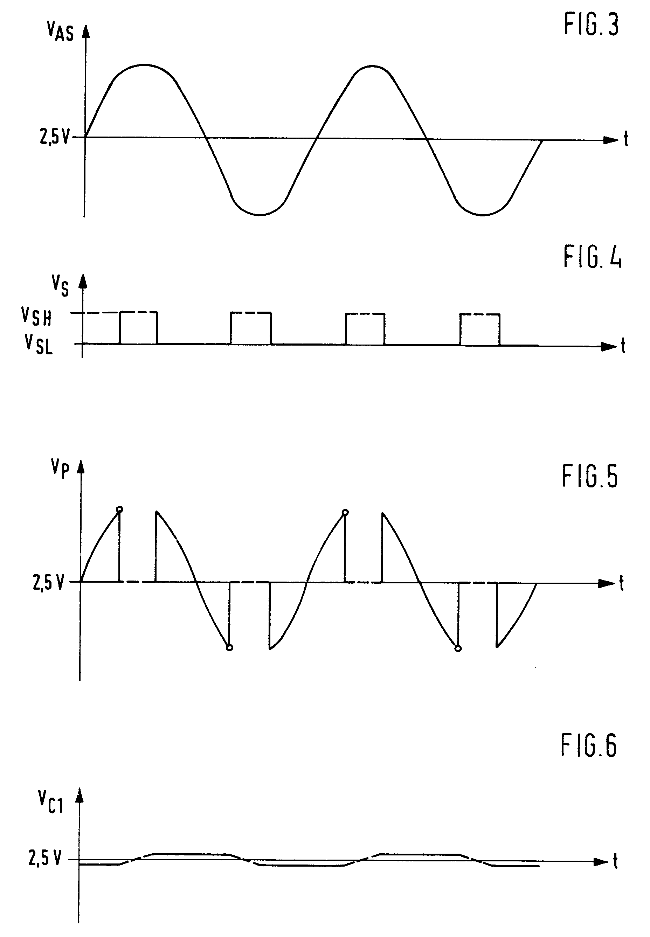

Zunächst wird die bereits vor der vorliegenden Erfindung existierende Analogsignal-Rechecksignal-Umformvorrichtung, wie sie in Fig. 2 dargestellt ist, betrachtet. Diese Schaltung weist einen Signaleingang SE auf, dem ein Analogsignal $V_{AS}$ zugeführt wird, beispielsweise der in Fig. 3 gezeigten Art. Zwischen dem Signaleingang SE und einem Signalausgang SA dieser Analogsignal-Rechtecksignal-Umformschaltung befinden sich in Reihenschaltung ein als Längskondensator angeordneter Offset-Speicherkondensator $C_{offs}$ und ein Komparator COM, mittels welchem eine schwellenwertabhängige Umformung des dem Signaleingang SE zugeführten Analogsignals in ein Rechtecksignal durchgeführt wird. Eine zum Signaleingang SE weisende erste Elektrode des Längskondensators $C_{offs}$ ist über einen ersten Umschalter U1 entweder mit dem Signaleingangsanschluß SE oder mit einem ersten Querkondensator C1 verbindbar, dessen von U1 abliegende Seite mit einem als Bezugspotentialanschluß dienenden Masseanschluß GND verbunden ist. Dem ersten Querkondensator C1 ist ein zweiter Querkondensator C2 parallel geschaltet, der über einen zweiten Umschalter U2 entweder mit dem Signaleingangsanschluß SE oder mit der zum ersten Umschalter U1 weisenden Elektrode des ersten Querkondensators C1 verbindbar ist. Die von U2 abliegende Elektrode von C2 ist ebenfalls mit dem Masseanschluß GND verbunden.

Der Längskondensator $C_{offs}$ besitzt eine parasitäre Kapazität $C_{par}$, die in Fig. 2 gestrichelt dargestellt ist und wie ein Kondensator wirkt, der zwischen die erste Elektrode von $C_{offs}$ und den Masseanschluß GND geschaltet ist.

Der Komparator COM weist einen Komparatorsi-gnaleingang CS, einen Komparatorreferenzspannungs-eingang CR und einen Komparatorausgang CA auf. CS und CA sind über einen EIN-/AUS-Schalter S1 miteinander verbunden, der im leitend gesteuerten Zustand den Komparatorausgang CA auf den Komparatorsignaleingang CS rückkoppelt. An den Komparatorreferenz-spannungseingang CR ist eine Referenzspannungs-quelle Vref angeschlossen, bei der es sich beispielsweise um die sogenannte Mittenspannung handelt, also um einen Gleichspannungswert von +2,5 Volt für den üblichen Fall, daß die in Fig. 2 gezeigte Schaltung mit einer Versorgungsspannung von +5 V betrieben wird.

Die in Fig. 2 gezeigte Schaltung nach dem Stand der Technik fünktioniert folgendermaßen:

In einer ersten Phase weisen die Schalter S1, U1 und U2 den mit durchgehender Linie dargestellten Schaltzustand auf, in einer zweiten Phase den gestrichelt dargestellten Schaltzustand. In der ersten Phase ist die Schaltung auf Signaldurchlaß eingestellt. Ein vom Signaleingangsanschluß SE kommendes Analogsignal, beispielsweise der in Fig. 3 gezeigten Art, wird über U1 und Coffs auf den Komparatorsignaleingang CS gegeben und wird vom Komparator COM schwellenabhängig in ein Rechtecksignal umgeformt, das am Signalausgangsanschluß SA verfügbar ist. Die Umformschwelle wird durch eine Referenzspannung Vref festgelegt, die dem nicht-invertierenden Kompara-torrefererzspannungseingang CR zugeführt wird. Übli-cherweise liegt CR auf der Mittenspannung von beispielsweise +2,5 V. Auf diesem Mittenspannungswert befindet sich im Idealfall auch der Signallängszweig zwischen SE und SA.

Komparatoren weisen üblicherweise eine Offset-Spannung auf, die für in MOS-Technik aufgebaute Komparatoren beträchtlich sein kann. Diese Offset-Spannung führt zu einem Offsetfehler, der sich wie eine Verfälschung der Umformschwelle auswirkt. Dies hat eine zeitliche Verschiebung des Auftretens der Flanken des am Komparatorausgang CA entstehenden Rechtecksignals zur Folge. Bei der in Fig. 2 gezeigten Schaltung wird eine Offsetkompensation dadurch erzielt, daß zu Fensterzeiten, die zwischen benachbarten Impulsflanken des am Komparatorausgang CA auftretenden Rechtecksignals liegen, der Schalter S1 in den (gestrichelt dargestellten) leitenden Zustand geschaltet wird. Aufgrund der dadurch entstehenden Rückkopplung über dem Komparator COM würden an CS, CR und CA die gleichen Spannungswerte, nämlich +2,5 V, auftreten, wäre der Komparator COM nicht offset-behaftet. Aufgrund des Offsetfehlers liegt während des Leitendschaltens von S1 der Komparatorsignaleingang CS um die Offsetspannung des Komparators COM über dem an CR auftretenden Spannungswert von +2,5 V. Liegt während dieser Phase der Schaltung in Fig. 2 die zum Signaleingangsanschluß SE weisende Elektrode von Coffs auf der Mittenspannung von +2,5 V, entsteht über dem Offsetspeicherkondensator $C_{offs}$ die Offsetspannung des Komparators COM. Während des nachfolgenden Betriebs der Schaltung in der ersten Phase, bei welcher Coffs über U1 wieder mit dem Signaleingangsanschluß SE verbunden ist, wird die in $C_{offs}$ gespeicherte Offsetpsannung dem Analogsignal überlagert und damit eine der Offsetspannung entsprechende Korrektur, das heißt, eine Offset-Kompensation, durchgeführt.

Für die relativen Kapazitätswerte von C1, C2 und $C_{offs}$ gilt:

$$C1 > > C2$$

$$C2 \approx C_{offs}$$

Während der zweiten Phase, in welcher die Umschalter U1 und U2 den gestrichelt dargestellten Schaltzustand aufweisen, wird C2 auf den Momentanwert der über SE zugeführten Analogsignalspannung aufgeladen. Um dies zu ermöglichen, ist der Kapazitätswert von C2 entsprechend gering gewählt. Aufgrund seines sehr viel größeren Kapazitätswertes integriert C1 die in C2 jeweils gespeicherte Signalamplitude während der ersten Phase, während welcher sich U2 in dem mit durchgezogener Linie dargestellten Schaltzustand befindet. In C2 ist somit der an SE auftretende Gleichspannungsarbeitspunkt gespeichert. Während der zweiten Phase, während welcher in $C_{offs}$ die Offsetspannung von COM gespeichert wird, liegt somit an der zum Signaleingangsanschluß SE weisenden Elektrode von $C_{offs}$ der über C1 gespeicherte Gleichspannungsarbeitspunkt. Dies stellt sicher, daß in $C_{offs}$ wirklich nur der Offsetspannungswert des Komparators COM gespeichert wird.

Da die parasitäre Kapazität $C_{par}$ üblicherweise kleiner als die Kapazität von $C_{offs}$ ist oder höchstens im gleichen Größenbereich, ist

$$C1 > > C_{par}.$$

$C_{par}$ läßt sich daher nicht für C1 nutzen. Von der Kapazitätsgröße her ließe sich Cpar zwar für C2 nutzen, was aber nicht möglich ist, weil C2 und $C_{par}$ bei keinem der Schaltzustände von U1 und U2 in den einzelnen Phasen parallel geschaltet sind.

Anders ist dies bei der in Fig. 1 gezeigten, erfindungsgemäß aufgebauten Analogsignal-Rechtecksignal-Umformschaltung. Hinsichtlich des den Komparator COM, den Schalter S1 und den Offsetspeicherkondensator $C_{offs}$ enthaltenden Schaltungsteils stimmt diese Schaltung mit der in Fig. 2 gezeigten Schaltung überein. Wesentlich verschieden ist sie hinsichtlich des restlichen Schaltungsteils. C2 ist permanent mit einem Schaltungspunkt P, und damit mit der zum Signaleingangsanschluß SE weisenden Elektrode von $C_{offs}$ verbunden. Damit liegen C2 und die parasitäre Kapazität $C_{par}$ von $C_{offs}$ permanent parallel und kann $C_{par}$ für die Bereitstellung der Kapazität von C1 benutzt werden. Da der Kapazitätswert von C2 und von $C_{par}$ in der gleichen Größenordnung liegen, kann der Betrag der Kapazität von C2 um den Betrag der Kapazität von

$C_{par}$ kleiner gemacht werden, als wenn es keine parasitäre Kapazität $C_{par}$ gäbe. Es mag Anwendungsfälle geben, bei denen C2 gänzlich durch $C_{par}$ ersetzt werden kann. Diese Verringerung des Kapazitätswertes von C2 gegenüber der in Fig. 2 gezeigten Schaltung führt dazu, daß für C2 entsprechend weniger Platz auf dem Chip der integrierten Schaltung benötigt wird oder, wenn C2 gänzlich durch $C_{par}$ ersetzt wird, der gesamte Platzbedarf für C2 wegfällt.

Anstelle der beiden Umschalter U1 und U2 bei der in Fig. 2 gezeigten Schaltung sind bei dem in Fig. 1 gezeigten erfindungsgemäßen Schaltungsaufbau zwei EIN-/AUS-Schalter S2 und S3 vorgesehen, und zwar zwischen dem Signaleingangsanschluß SE und dem Schaltungspunkt P beziehungsweise zwischen dem Schaltungspunkt P und dem Kondensator C2.

Die relative Dimensionierung von C1, C2 und $C_{offs}$ ist die gleiche wie zuvor für Fig. 2 angegeben.

In einer ersten Phase, in welcher Signaldurchlaß zwischen SE und SA besteht, befinden sich die Schalter S1 bis S3 in dem mit einer durchgezogenen Linie dargestellten Schaltzustand, während sie sich während einer zweiten Phase in dem gestrichelten Schaltzustand befinden. In der ersten Phase ist somit S2 leitend gesteuert, während S1 und S3 nicht-leitend gesteuert sind. In der zweiten Phase sind S1 und S3 leitend gesteuert, während S2 nicht-leitend gesteuert ist.

Unter Zuhilfenahme der Figuren 3 bis 6 wird nun die Arbeitweise der in Fig. 1 gezeigten Schaltung näher erläutert:

Es wird wieder angenommen, daß dem Signaleingangsanschluß SE eine sinusförmige Analogspannung $V_{AS}$ gemäß Fig. 3 zugeführt wird, deren Mittelwert oder Gleichspannungsarbeitspunkt bei 2,5 V liegt. In Fig. 4 ist ein Schaltersteuersignal $V_S$ dargestellt. Während der ersten Phase, wahrend welcher $V_S$ einen mit durchgezogenen Linien dargestellten niedrigen Potentialwert $V_{SL}$ aufweist, befinden sich die Schalter S1 bis S3 in dem mit durchgezogenen Linien gezeigten Schaltzustand. Während der zweiten Phase, während welcher $V_S$ einen gestrichelt dargestellten hohen Potentialwert $V_{SH}$ annimmt, befinden sich die Schalter S1 bis S3 in den gestrichelt dargestellten Schaltzuständen.

In der ersten Phase, in welcher S2 leitend gesteuert ist, besteht Signaldurchlaß zwischen SE und SA. In dieser Phase wird C2 auf den momentanen Amplitudenwert der über SE zugeführten Analogsignalspannung $V_{AS}$ aufgeladen. Wegen des nicht-leitend gesteuerten Schalters S3 sind wahrend dieser Phase C1 und C2 voneinander getrennt. Schalter S1 ist nicht-leitend gesteuert, so daß zwischen CS und CA keine Rückkopplung besteht.

In der zweiten Phase, während welcher S1 bis S3 die gestrichelt dargestellten Schaltzustände aufweisen, ist der Signalweg zwischen SE und SA unterbrochen, ist C2 zu C1 parallel geschaltet und ist der Komparator COM über S1 rückgekoppelt. In dieser Phase integriert C1 den in C2 gespeicherten Amplitudenwert, den die Analogsignalspannung $V_{AS}$ zum Zeitpunkt des Öffnens von S2, also zu Beginn der zweiten Phase aufwies. In C1 ist somit genauso wie im Fall der Fig. 2 der Gleichspannungsarbeitspunkt der Analogsignalspannung $V_{AS}$ gespeichert. Während des Vorgangs der Messung der Offsetspannung des Komparators COM und der Einspeicherung dieser Offsetspannung in den Offsetspeicherkondensator $C_{Offs}$ befindet sich somit die zum Schaltungspunkt P weisende Elektrode von $C_{Offs}$ auf dem Gleichspannungsarbeitspunkt von $V_{AS}$. Daher wird auch im Fall von Fig. 1 in $C_{Offs}$ nur die Offsetspannung gespeichert.

Fig. 5 zeigt den Spannungsverlauf $V_P$ der Analogsignalspannung am Schaltungspunkt P. Dabei gehören die durchgezogen dargestellten Signalverläufe zu den ersten Phasen, also den mit durchgezogenen Linien gezeichneten Schalterzuständen in Fig. 1, während die gestrichelten Teile zu den Phasen 2 gehören, also zu den in Fig. 1 gestrichelt dargestellten Schalterzuständen. Dabei ist vereinfachend angenommen, daß der Amplitudenwert von $V_P$ während der zweiten Phasen auf den Mittelwert oder Gleichspannungsarbeitspunkt 2,5 V zurückgeht. Dies stimmt genau genommen nicht ganz, wie anhand von Fig. 6 gezeigt ist. Da Kondensator C2 bei jedem Übergang von der Phase 1 auf die Phase 2 auf den zu diesem Zeitpunkt existierenden Amplitudenwert von $V_{AS}$ aufgeladen ist, und zwar auf Spannungswerte, die in Fig. 5 mit kleinen Kreisen markiert sind, verändert sich während der jeweiligen Phase 2 die Integrationsspannung über dem Kondensator C1. Dies ist in Fig. 6 in Form der gestrichelten Anstiegsbzw. Abfallrampen dargestellt. Weist der Spannungsverlauf $V_P$ am Ende der ersten Phase einen positiven Amplitudenwert auf, steigt die in Fig. 6 gezeigte Spannung Vc2 während der nachfolgenden zweiten Phase an. Befand sich der Spannungsverlauf $V_P$ am Ende der jeweiligen ersten Phase auf einem negativen Amplitudenwert, fällt der Spannungswert VC1 über C1 während der jeweils nachfolgenden zweiten Phase ab. Über dem Kondensator C1 ist somit im wesentlichen der Gleichspannungsarbeitspunkt beziehungsweise die Mittenspannung 2,5 V gespeichert, mit geringfügigen Schwankungen über und unter diesen Mittenwert von 2,5 V. Daher liegt an der zum Schaltungspunkt P weisenden Elektrode des Offsetspeicherkondensators $C_{Offs}$ praktisch die Mittenspannung von 2,5 V an, so daß die während einer Phase 2 in $C_{Offs}$ gespeicherte Spannung praktisch die Offsetspannung des Komparators COM darstellt.

Die in Fig. 1 gezeigte erfindungsgemäß aufgebaute Schaltung kommt somit im Gegensatz zu der in Fig. 2 gezeigten bereits existierenden Schaltung mit zwei EIN-/AUS-Schaltern aus. Außerdem kann der Kapazitätswert von C2 um den Wert der parasitären Kapazität $C_{par}$ kleiner sein als im Fall der Fig. 2. Für den Fall, daß die parasitäre Kapazität $C_{par}$ für den Zweck der jeweiligen Amplitudenwertspeicherung ausreicht, kann C2 ganz eingespart werden. Somit wird der bereits angesprochene Effekt erreicht, daß Chipfläche einerseits durch Reduzierung oder Wegfall der Kapazität des Kondensators C2 und andererseits durch Verwendung von EIN-/AUS-Schaltern anstatt von Umschaltern eingespart wird.

## Patentansprüche

1. Monolithisch integrierte Signalverarbeitungsschaltung,

   a) mit einem zwischen einen Signaleingangsanschluß (SE) und einen Signalausgangsanschluß (SA) geschalteten Signallängszweig;
   b) mit einem Bezugspotentialanschluß (GND);
   c) mit einem seriell in den Signallängszweig eingefügten Längskondensator ($C_{Offs}$), der eine parasitäre Kapazität ($C_{par}$) aufweist, die wie ein Kondensator wirkt, der zwischen eine zum Signaleingangsanschluß (SE) weisende erste Elektrode des Längskondensators ($C_{Offs}$) und den Bezugspotentialanschluß (GND) geschaltet ist;
   d) und mit einem ersten Querkondensator (C2), der unmittelbar zwischen die erste Elektrode des Längskondensators ($C_{Offs}$) und den Bezugspotentialanschluß (GND) geschaltet ist;
   e) wobei der erste Querkondensator (C2) mindestens teilweise durch die parasitäre Kapazität ($C_{par}$) gebildet ist.

2. Signalverarbeitungsschaltung nach Anspruch 1, bei welcher der Querkondensator (C2) zu einem Tiefpaßfilter gehört.

3. Signalverarbeitungsschaltung nach Anspruch 1, als Teil einer offsetkompensierten Analogsignal-Rechtecksignal-Umformschaltung, bei welcher

   a) der erste Querkondensator (C2) in einem Schaltungspunkt (P) mit dem Signallängszweig verbunden ist;
   b) zwischen den Signaleingangsanschluß (SE) und den Schaltungspunkt (P) ein erster steuerbarer EIN-/AUS-Schalter (S2) geschaltet ist, der im leitend gesteuerten Zustand den Schaltungspunkt (P) mit dem Signaleingangsanschluß (SE) verbindet;
   c) zwischen den Schaltungspunkt (P) und den Bezugspotentialanschluß (GND) eine Reihenschaltung mit einem zweiten Querkondensator (C1) und einem zweiten steuerbaren EIN-/AUS-Schalter S3 geschaltet ist, wobei der zweite Schalter S3 im leitend gesteuerten Zustand den zweiten Querkondensator C1 zum ersten Querkondensator C2 parallel schaltet;
   d) zwischen den Längskondensator ($C_{Offs}$) und

den Signalausgangsanschluß (SA) ein offset-behafteter Komparator (COM) geschaltet ist, mittels welchem ein Analogsignal ($V_{AS}$) schwellenabhängig in ein Rechtecksignal umformbar ist und der einen mit dem Längskondensator ($C_{offs}$) verbundenen Komparatorsignaleingang (Cs), einen mit einem Referenzpotentialanschluß (Vref) verbundenen Komparatorreferenzspannungseingang (CR) zum Anschluß an ein schwellenbestimmendes Referenzpotential und einen zum Signalausgangsanschluß (SA) weisenden Komparatorausgang (CA) aufweist;

e) und zwischen den Komparatorsignaleingang (CS) und den Komparatorausgang (CA) ein steuerbarer dritter Schalter (S1) geschaltet ist, der im leitend gesteuerten Zustand den Komparatorsignaleingang (CS) und den Komparatorausgang (CA) miteinander verbindet; wobei

f) der Längskondensator ($C_{offs}$) als Offsetspeicherkondensator dient;

g) während Fensterzeiten, die zwischen dem Auftreten benachbarter Flanken des Rechtecksignals liegen, der erste Schalter (S2) in den nicht-leitenden und der zweite Schalter (S3) und der dritte Schalter (S1) in den leitenden Zustand steuerbar sind; und

h) während der restlichen Zeit der erste Schalter (S2) in den leitenden und der zweite Schalter (S3) und der dritte Schalter (S1) in den nicht-leitenden Zustand steuerbar sind.

4. Signalverarbeitungsschaltung nach Anspruch 3, bei welcher die Kapazität des zweiten Querkondensators (C1) sehr viel größer ist als die Kapazität des ersten Querkondensators (C2) und des Längskondensators ($C_{offs}$).

5. Signalverarbeitungsschaltung nach Anspruch 3 oder 4, bei welcher die Kapazitäten von Längskondensator ($C_{offs}$) und erstem Querkondensator (C2) in etwa gleich groß sind.

# FIG.1

# FIG.2

FIG. 3

$V_{AS}$

2,5 V

t

FIG. 4

$V_S$

$V_{SH}$
$V_{SL}$

t

FIG. 5

$V_P$

2,5 V

t

FIG. 6

$V_{C1}$

2,5 V

t